# EUROPÄISCHE PATENTSCHRIFT

(11) **EP 1 308 074 B1**
(45) Veröffentlichungstag und Bekanntmachung des Hinweises auf die Patenterteilung: **25.02.2009**
(21) Anmeldenummer: 01957748.5
(22) Anmeldetag: 02.08.2001
(51) Int. Cl.: H05K 13/00

(54) **VERFAHREN ZUM BETREIBEN EINER BESTÜCKANLAGE, BESTÜCKANLAGE ZUR DURCHFÜHRUNG DES VERFAHRENS UND ÜBERGABEEINRICHTUNG FÜR DIE BESTÜCKANLAGE**
METHOD FOR THE OPERATION OF A COMPONENT PLACEMENT UNIT, COMPONENT PLACEMENT UNIT FOR CARRYING OUT SAID METHOD AND FEED DEVICE FOR SAID COMPONENT PLACEMENT UNIT
PROCEDE PERMETTANT DE FAIRE FONCTIONNER UNE INSTALLATION D'IMPLANTATION DE COMPOSANTS, INSTALLATION D'IMPLANTATION DE COMPOSANTS PERMETTANT LA MISE EN OEUVRE DU PROCEDE, ET DISPOSITIF DE TRANSFERT DESTINE A L'INSTALLATION D'IMPLANTATION DE COMPOSANTS

(30) Priorität: 10.08.2000 DE 10039201
(43) Veröffentlichungstag der Anmeldung: 07.05.2003
(73) Patentinhaber: SIEMENS AKTIENGESELLSCHAFT, 80333 München (DE)
(72) Erfinder: BECK, Erwin, 85244 Röhrmoos (DE); BLÖMER, Ralf, 47506 Neukirchen-Vluyn (DE)
(86) Internationale Anmeldenummer: PCT/DE2001/002934
(87) Internationale Veröffentlichungsnummer: WO 2002/013589

(56) Entgegenhaltungen:
- EP-A- 0 302 542
- EP-A- 0 413 098
- EP-A- 0 491 448
- WO-A-01/45482

## Beschreibung

Die Erfindung betrifft ein Verfahren zum Betreiben einer Bestückanlage zum Bestücken von Bauelementeträgern mit elektrischen Bauelementen, eine Bestückanlage zur Durchführung des Verfahrens sowie eine Übergabeeinrichtung für eine derartige Bestückanlage.

Herkömmlicherweise weist eine Bestückanlage zum Bestücken von Bauelementeträgern, wie beispielsweise elektrischen Leiterplatten, eine Mehrzahl von Verarbeitungsplätzen, wie beispielsweise Siebdrucker, Bestückautomaten, Lötofen oder Prüfgeräte, sowie eine im wesentlichen geradlinig verlaufende Transportstrecke auf, mittels welcher die Verarbeitungsplätze miteinander verbunden sind. Mittels der Transportstrecke können Bauelementeträger von der Bestückanlage abhängig von der Anzahl der pro Bauelementeträger zu bestückenden elektrischen Bauelemente gleichzeitig in mehreren Verarbeitungsplätzen parallel verarbeitet werden oder bei einer größeren Anzahl von elektrischen Bauelementen seriell verarbeitet werden. Dadurch können zum einen Baugruppen, die eine große Vielfalt unterschiedlicher Bauelemente benötigen, vollständig bestückt werden, ohne daß an den Verarbeitungsplätzen Umrüstarbeiten erforderlich sind. Zum anderen können weniger komplexe Bauelementeträger in großer Anzahl parallel mit mehreren Bestückautomaten gleichzeitig bestückt werden und anschließend beispielsweise in einen gemeinsamen Lötofen geführt werden.

Bei herkömmlichen Bestückanlagen werden die Bauelementeträger an einem Anfangsbereich der Bestückanlagen angeliefert und von einer Zuführeinrichtung in diese eingegeben. Mittels der Transportstrecken werden die Bauelementeträger über die Verarbeitungsplätze geführt und dabei verarbeitet. Nach Abschluß der Verarbeitung ist es erforderlich, die fertig verarbeiteten Bauelementeträger am Ende der Bestückanlage abzuholen. Sollen Bauelementeträger beispielsweise auf beiden Seiten bearbeitet werden, so ist es erforderlich, die Bauelementeträger über eine zusätzliche externe Transportstrecke zum Anfang der Bestückanlage zurück zu transportieren. Hierzu sind jedoch sowohl eine zusätzliche Übergabestation, von welcher die fertig verarbeiteten Bauelementeträger an die externe Transportstrecke übergeben werden können, sowie eine externe Transportstrecke erforderlich. Beide benötigen zusätzlichen Platz und erhöhen die Verarbeitungsdauer, da die Bauelementeträger, ehe sie zum Anfang der Bestückanlage zurücktransportiert werden können, zunächst die gesamte Anlage durchlaufen müssen. Mit einer derartigen Anordnung können jedoch die unterschiedlichen Verarbeitungsplätze einer Bestückanlage nicht optimal genutzt werden (siehe EP-A-0302542).

Der Erfindung liegt die Aufgabe zugrunde, ein Verfahren zum Betreiben einer Bestückanlage, eine Bestückanlage zur Durchführung des Verfahrens und eine Übergabeeinrichtung für die Bestückanlage anzugeben, welche eine hinsichtlich der erforderlichen Verarbeitungszeit und des erreichbaren Durchsatzes optimale Verarbeitung gewährleistet.

Die Aufgabe wird durch die Erfindung gemäß den unabhängigen Ansprüchen gelöst. Bevorzugte Ausgestaltungen der Erfindung sind in den abhängigen Ansprüchen beansprucht.

Die Erfindung schafft ein Verfahren zum Betreiben einer Bestückanlage zum Bestücken von Bauelementeträgern mit elektrischen Bauelementen, wobei die Anlage eine Mehrzahl von Verarbeitungsplätzen aufweist. Die Verarbeitungsplätze sind über eine oder mehrere Transportstrecken miteinander verbunden, von welchen die Bauelementeträger in einer Haupt-Transportrichtung transportiert werden. Bei dem erfindungsgemäßen Verfahren werden Bauelementeträger über die Transportstrecke in der Haupt-Transportrichtung zu den Verarbeitungsplätzen transportiert. Die Bauelementeträger und/oder die elektrischen Bauelemente werden an den Verarbeitungsplätzen verarbeitet. Ferner wird zumindest zeitweise die Haupt-Transportrichtung einer oder mehrerer der Transportstrecken umgekehrt, wodurch die Bauelementeträger in der Gegen-Transportrichtung von einem Verarbeitungsplatz zu einem anderen Verarbeitungsplatz transportiert werden.

Durch die Erfindung ist es beispielsweise möglich, Bauelementeträger, welche bereits den letzten Verarbeitungsplatz der Bestückanlage durchlaufen haben, mittels der mit dem Verarbeitungsplatz verbundenen Transportstrecke zurück zu einem beliebigen anderen Verarbeitungsplatz der Bestückanlage zu transportieren. Dies ist beispielsweise beim beidseitigen Bestücken von Bauelementeträgern mit unterschiedlichen oder gleiche Bauelementen sinnvoll. Ferner kann es auch erforderlich sein, einen Bearbeitungsschritt mehrfach auszuführen, wie beispielsweise ein mehrfacher Durchlauf durch eine bestimmte Verarbeitungseinheit, wie beispielsweise einen Ofen. Darüber hinaus kann es hinsichtlich der Optimierung der Durchlaufzeiten durch die Bestückautomaten sinnvoll sein; mittels variabler Transporte in der Haupt-Transportrichtung und in der Gegen-Transportrichtung die noch nicht vollständig bestückten Bauelementeträger zwischen den Bestückautomaten zu transportieren, um eine optimale Auslastung der Bestückplätze der Bestückautomaten zu erreichen.

Nach einem Gesichtspunkt der Erfindung kann es erforderlich sein, vor einem Transportieren von Bauelementeträgern in der Gegen-Transportrichtung zu prüfen, ob unter Optimierungsgesichtspunkten ein Transportieren in der Gegen-Transportrichtung auf einer oder mehreren Transportstrecken sinnvoll ist. Es kann hierzu beispielsweise überprüft werden, ob alle Bestückplätze der Bestückautomaten gerade mit einem Bauelementeträger, welcher bestückt werden soll, versorgt sind, so daß keine Versorgungstransporte zu den Bestückautomaten erforderlich sind. In diesem Zustand können die an den Bestückautomaten vorhandenen Transportstrecken problemlos zum Rücktransport von Bauelementeträgern in der Gegen-Transportrichtung genutzt werden.

Nach einem weiteren Gesichtspunkt der Erfindung kann es auch erforderlich sein, die Bauelementeträger, welche in der Gegen-Transportrichtung transportiert werden sollen, an den Verarbeitungsplätzen oder zwischen den Verarbeitungsplätzen zwischenzuspeichern. Hierzu können Zwischenspeicher vorgesehen sein, welche eine unterschiedliche Anzahl von Bauelementeträgern aufnehmen können. Mit Erreichen einer wählbaren Anzahl von Bauelementeträgern in dem Zwischenspeicher kann ein Transportieren in der Gegen-Transportrichtung auf einer oder mehreren Transportstrecken der Bestückanlage durchgeführt werden. Hierdurch werden die Transportstrecken der Bestückanlage nur für kurze Zeit durch die Transporte in der Gegen-Transportrichtung belastet.

Erfindungsgemäß wird auch eine Bestückanlage zur Durchführung des erfindungsgemäßen Verfahrens geschaffen. Eine derartige Bestückanlage ist mit einer Mehrzahl von Verarbeitungsplätzen sowie einer oder mehreren Transportstrecken versehen. Die Haupt-Transportrichtung der Transportstrecken der Bestückanlage ist für Transporte von einem Verarbeitungsplatz zu einem anderen Verarbeitungsplatz selektiv umkehrbar.

Die Transportstrecke und/oder die Verarbeitungsplätze können mit einer Steuereinheit gekoppelt sein. Von dieser Steuereinheit können auf Basis von ermittelten Zustandsinformationen der Transportstrecken die Auslastungen der Transportstrecken überprüft werden. Daher ist mittels der Steuereinheit eine verläßliche Aussage möglich, ob ein Umkehren der Haupt-Transportrichtung und Transportieren von Bauelementeträgern in der Gegen-Transportrichtung ohne Beeinträchtigung der von den Verarbeitungsplätzen durchgeführten Verarbeitung der Bauelementeträger möglich ist.

Nach einem weiteren Aspekt der Erfindung wird eine Übergabeeinrichtung für eine Bestückanlage geschaffen, welche bei einer Bestückanlage mit wenigstens zwei Transportstrecken und einer Mehrzahl von über die Transportstrecken verbundenen Verarbeitungsplätzen zum Verarbeiten von Bauelementeträgern und/oder elektrischen Bauelementen verwendet werden kann. Die Übergabeeinrichtung weist wenigstens zwei Teiltransportstrecken auf, welche vertikal und/oder horizontal verschiebbar sind und zumindest temporär mit den Transportstrecken fluchten. Die Haupt-Transportrichtung der Teiltransportstrecken der Übergabeeinrichtung ist dabei selektiv umkehrbar. Es ist ein Umsetzen oder auch Übergeben von Bauelementeträgern zwischen den Transportstrecken möglich. So kann bei zwei oder mehr Transportstrecken der Bestückanlage der Transportbetrieb in der Gegen-Transportrichtung durch selektives Nutzen von jeweils freien Transportstrecken derart optimiert werden, daß die Verarbeitung in Haupt-Transportrichtung nicht verzögert wird.

Die Erfindung wird unter Bezugnahme auf die Zeichnung anhand bevorzugter Ausführungsformen näher erläutert. In der Zeichnung zeigen:
Figur 1 eine schematische Ansicht einer Bestückanlage mit mehreren Verarbeitungsplätzen und mehreren Transportstrecken nach einer bevorzugten Ausführungsform der Erfindung,
Figur 2 eine perspektivische schematische Ansicht einer Übergabeeinrichtung nach einer bevorzugten Ausführungsform der Erfindung,
Figur 3 eine schematische perspektivische Ansicht eines Bestückautomaten und Übergabeeinrichtungen aufweisenden Abschnitts einer Bestückanlage nach einer bevorzugten Ausführungsform der Erfindung, und
Figur 4 eine schematische Funktionsansicht des Abschnitts der Bestückanlage nach Figur 3.

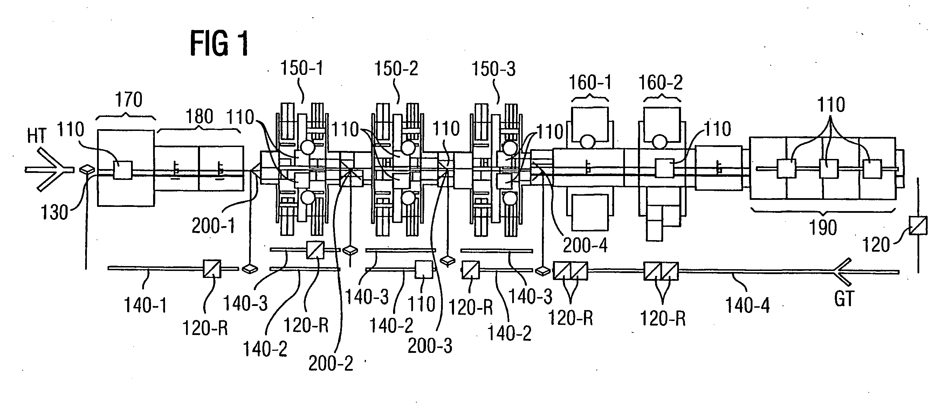

Wie aus Figur 1 ersichtlich, weist eine Bestückanlage nach einer bevorzugten Ausführungsform der Erfindung eine Mehrzahl von Verarbeitungsplätzen 150-1, 150-2, 150-3, 160-1, 160-2, 180, 170 und 190 auf. Die unterschiedlichen Verarbeitungsplätze können beispielsweise eine Zuführeinheit für Bauelementeträger 170, eine Siebdruckeinheit 180 zum Bedrucken der Bauelementeträger mit Lotpaste, Bestückautomaten 150-1, 150-2, 150-3, Sonderbestückautomaten 160-1, 160-2, oder ein Lötofen 190 sein. Es sind jedoch auch andere Verarbeitungsplätze möglich, wie beispielsweise Prüfgeräte.

Die Verarbeitungsplätze kreuzen sich mit einer Mehrzahl von Transportstrecken 130 und 140, d.h. sind über die Transportstrecken 130 miteinander verbunden. Die Transportstrecken 130 und 140 sind jeweils in mehrere, beispielsweise den einzelnen Verarbeitungsplätzen angepasste Abschnitte unterteilt. Zu bestückende Bauelementeträger 110 sind an unterschiedlichen Orten der Bestückanlage in der Figur 1 gezeigt. Beispielsweise ist ein Bauelementeträger 110 in der Zuführeinheit 170 angeordnet. Jeweils zwei Bauelementeträger 110 sind in jedem der Bestückautomaten 150-1, 150-2, 150-3 angeordnet.

Die Haupt-Transportrichtung HT der Bestückanlage ist durch den Pfeil HT angedeutet und verläuft von der Zuführeinheit 170 über die Siebdrucker 180 zu den Bestückautomaten 150-1, 150-2, 150-3 und von diesem über die Sonderbestückautomaten 160-1, 160-2 zu dem Lötofen 190. An dem in der Haupt-Transportrichtung HT gesehen letzten Bestückautomaten 150-3 sind zwei Bauelementeträger 110 in einer Abholposition ersichtlich gezeigt, von welcher aus sie mittels der Transportstrecke 130 den Sonderbestückautomaten 160-1 und 160-2 zugeführt werden. Zwei weitere Bauelementeträger 110 sind am Eingangsabschnitt des in der Haupt-Transportrichtung HT letzten Bestückautomaten 150-3 dargestellt. Diese werden, nachdem die in der Abholposition befindlichen Bauelementeträger 110 mittels der Transportstrecke aus dem Bestückautomaten 150-3 entfernt worden sind, in die Bestückpositionen des Bestückautomaten 150-3 transportiert.

Aus der Figur 1 ist ebenfalls ersichtlich, daß sich in dem Sonderbestückautomaten 160-2 ein Bauelementeträger 110 und in dem Lötofen 190 drei Bauelementeträger 110 befinden. Figur 1 gibt dabei die Belegung der einzelnen Verarbeitungsplätze und Transportstrecken 130, 140 während eines beliebigen Zeitpunktes des Betriebs der Bestückanlage nach der bevorzugten Ausführungsform der Erfindung wieder. Die unterhalb der Verarbeitungsplätze gezeigte Transportstrecke 140 ist in mehrere Abschnitte 140-1, 140-2, 140-3 und 140-4 unterteilt. Der Abschnitt 140-1 verläuft im Bereich der Zuführeinheit 170 und des Siebdruckers 180. Die Abschnitte 140-2 und 140-3 bilden zwei parallele Transportstrecken im Bereich der Bestückautomaten 150-1, 150-2 und 150-3. Der Abschnitt 140-4 verläuft im Bereich der Sonderbestückautomaten 160-1 und 160-2 sowie des Lötofens 190. In dem Abschnitt 140-4 ist die Transportstrecke 140 mit mehreren teilweise oder vollständig bestückten Bauelementeträgern 120-R besetzt.

Auf den Abschnitten 140-1, 140-2, 140-3 und 140-4 sind in der Gegen-Transportrichtung GT zu transportierende Bauelementeträger 120-R angeordnet, welche erfindungsgemäß in der Gegen-Transportrichtung transportiert werden. Sie können bereits vollständig bestückt oder teilweise bestückt oder zum Teil auch bereits gelötet sein.

Der im Bereich des Lötofens 190 und der Sonderbestückautomaten 160 angeordnete Abschnitt 140-4 der Transportstrecke 140 ist in der Lage, eine Mehrzahl von teilweise oder vollständig bestückten und/oder gelöteten Bauelementeträgern 120-R, welche in der Gegen-Transportrichtung GT der Bestückanlage transportiert werden sollen, zwischenzuspeichern. Die unterhalb der Bestückautomaten 150-1, 150-2 und 150-3 dargestellten und diesen zugeordneten Transportstrecken 140-2 und 140-3 sind, beispielsweise bei Parallelbetrieb der Bestückautomaten 150-1, 150-2 und 150-3 mittels der Übergabeeinrichtungen 200-1, 200-2, 200-3 und 200-4, zwischen den Bestückautomaten 150-1, 150-2, 150-3 stark frequentiert. Daher können die teilweise oder vollständig bestückten Bauelementeträger 120-R nicht kontinuierlich in der Gegen-Transportrichtung GT über die Transportstrecken 140-2 und 140-3 im Bereich der Bestückautomaten 150-1, 150-2, 150-3 transportiert werden. Somit ist die Zwischenspeicherung von teilweise oder vollständig bestückten und/oder gelöteten Bauelementeträgern 120-R in dem Abschnitt 140-4 der Transportstrecke 140 erforderlich. Sind die Transportstrecken 140-2 und 140-3 der Bestückautomaten 150-1, 150-2 und 150-3 in der Gegen-Transportrichtung GT durchgehend passierbar, d.h., werden zu einem Zeitpunkt keine noch nicht vollständig bestückten Bauelementeträger 110, in der Haupt-Transportrichtung HT auf den Transportstrecken 140-2 und 140-3 der Bestückautomaten 150-1, 150-2 und 150-3 transportiert, so können die zwischengespeicherten Bauelementeträger 120-R über die Transportstrecken 140-2 und 140-3 in der Gegen-Transportrichtung GT transportiert werden. Die Transportstrecken 140-2 und 140-3 sind jeweils mittels Übergabeeinrichtungen 200-1, 200-2, 200-3 und 200-4 miteinander verbunden. Daher kann der Transport in der Gegen-Transportrichtung GT der Bestückanlage auf den Transportstrecken 140-2 und 140-3 von der einen Transportstrecke 140-2 auf die andere Transportstrecke 140-3 und anders herum beliebig gewechselt werden, da mittels der Übergabeeinrichtungen 200-1, 200-2, 200-3 und 200-4 ein Wechsel der Transportstrecken 140-2 und 140-3 nach jedem Teilabschnitt der Transportstrecken 140-2 und 140-3 möglich ist. Die Übergabeeinrichtungen 200-1, 200-2, 200-3 und 200-4 können zusätzliche Zwischenspeicher aufweisen, welche die Effizienz der Bestückanlage noch weiter steigern.

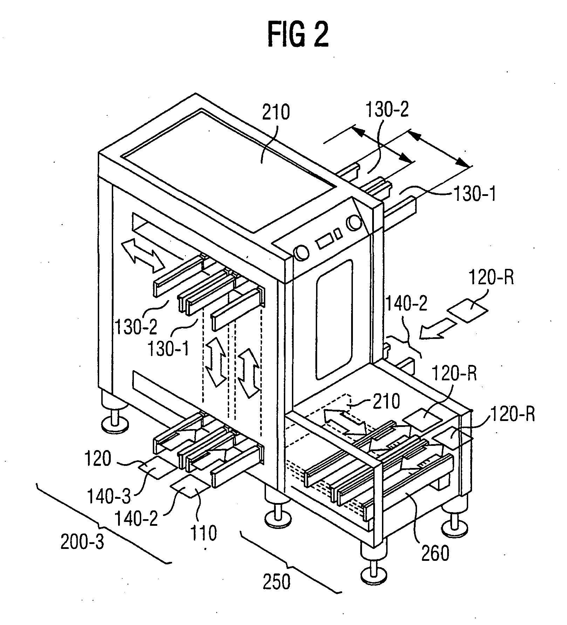

Aus Figur 2 ist eine schematische perspektivische Ansicht einer Übergabeeinrichtung 200-3 nach einer bevorzugten Ausführungsform der Erfindung ersichtlich. Die Übergabeeinrichtung 200-3 ist an mehreren Stellen Transportstrecken 130-1, 130-2, 140-2 und 140-3 der Bestückanlage zugewandt und kann, beispielsweise mittels einer oder mehreren förderbandartig ausgebildeten Teiltransportstrecken 210, die von diesen transportierten Bauelementeträger 110, 120 und 120-R entgegennehmen bzw. Bauelementeträger 110, 120 und 120-R an diese abgeben.

Von der Übergabeeinrichtung 200-3 sind miteinander fluchtende Transportstrecken 130-1, 130-2, 140-2 und 140-3 über die mindestens eine Teiltransportstrecke 210 miteinander verbindbar. Bei als parallele Doppel- oder Mehrfachtransportstrecken ausgebildeten Transportstrecken 130-1, 130-2, 140-2 und 140-3, verläuft auch die Teiltransportstrecke 210 der Übergabeeinrichtung 200-3 parallel in demselben Abstand wie die Transportstrecken 130-1, 130-2 bzw. 140-2, 140-3.

Die Teiltransportstrecke 210 ist, wie durch die Pfeile in Vertikal- und in Horizontalrichtung angedeutet, vertikal und/oder horizontal verschiebbar. Dadurch können auf den Transportstrecken 130-1, 130-2, 140-2 und 140-3 transportierte Bauelementeträger 110, 120 und 120-R wahlweise an eine der Transportstrecken 130-1, 130-2, 140-2 oder 140-3 übergeben werden. Das heißt, die Bauelementeträger 110, 120 oder 120-R, welche entweder in Haupt-Transportrichtung HT oder in der Gegen-Transportrichtung GT an die Übergabeeinrichtung 200-3 herantransportiert werden, können von derjenigen Transportstrecke 130-1, 130-2, 140-2 oder 140-3, auf welcher sie herantransportiert werden, an eine beliebige andere der Transportstrecken 130-1, 130-2, 140-2 oder 140-3 übergeben und auf dieser weitertransportiert werden.

Gemäß einer weiteren Ausgestaltung der Erfindung kann die Übergabeeinheit 200-3 zusätzlich mit einem Zwischenspeicher 250 versehen sein. Der Zwischenspeicher 250 weist zusätzliche Teiltransportstrecken 260 auf, welche, wie in der Figur gezeigt, in horizontaler Richtung gegenüber den Transportstrecken 130-1, 130-2, 140-2 und 140-3 verschiebbar sind. Die zusätzlichen Teiltransportstrecken können zusätzlich oder alternativ auch vertikal verschiebbar sein. Dadurch können von den Transportstrecken 130-1, 130-2, 140-2 und 140-3 Bauelementeträger 110, 120 oder 120-R auf die zusätzlichen Teiltransportstrecken 260 des Zwischenspeichers 250 gespeichert werden und anschließend zusammen mit den zusätzlichen Teiltransportstrecken 260 aus dem Transportweg verschoben werden, wobei die mindestens eine Teiltransportstrecke 210 der Übergabeeinheit 200-3 in den Transportweg der Transportstrecken 130-1, 130-2, 140-2 und 140-3 verschiebbar ist, so daß eine Verbindung zwischen fluchtenden Transportstrecken möglich ist.

Bei Bedarf kann die mindestens eine Teiltransportstrecke 210 in dem Transportweg der Transportstrecken 130-1, 130-2, 140-2 und 140-3 erneut gegen die Teiltransportstrecken 260 gewechselt werden und die gespeicherten Bauelementeträger 110, 120 oder 120-R werden aus dem Zwischenspeicher 250 in den Transportweg der Transportstrecken gebracht.

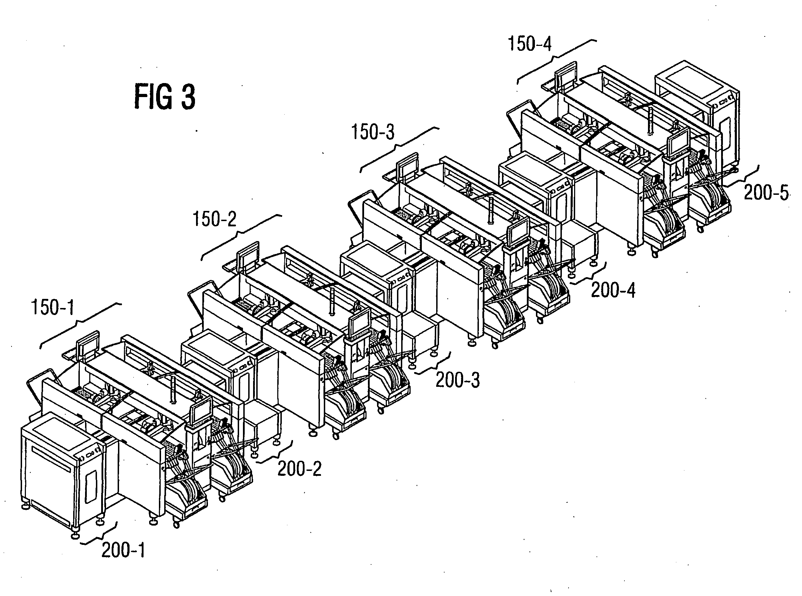

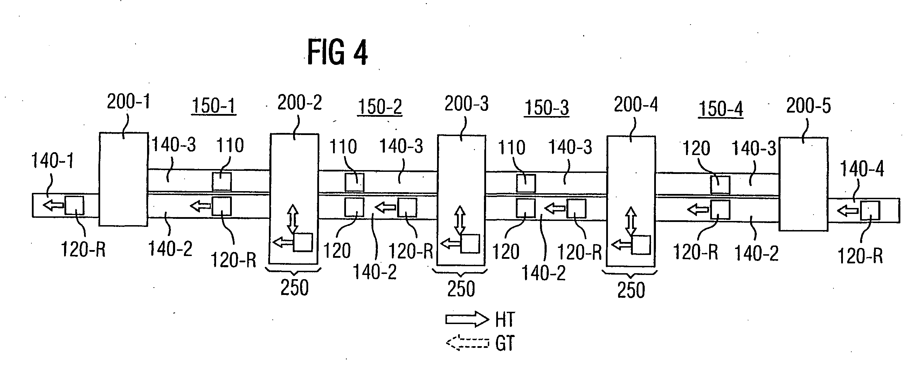

Aus den Figuren 3 und 4 sind eine perspektivische schematische und eine schematische Funktionsansicht eines Abschnitts einer Bestückanlage ersichtlich, welcher vier Bestückautomaten 150-1, 150-2, 150-3 und 150-4 und fünf Übergabeeinrichtungen 200-1, 200-2, 200-3, 200-4 und 200-5 aufweist. Die Bestückanlage ist im Bereich der Bestückautomaten 150-1, 150-2, 150-3 und 150-4 mit zwei parallelen Transportstrecken 140-2 und 140-3 versehen. In Haupt-Transportrichtung HT gesehen, am Anfang und am Ende des Abschnitts der Bestückanlage, ist jeweils eine Transportstrecke 140-1 bzw. 140-4 ersichtlich. Mittels der Transportstrecken 140-1 bzw. 140-4 werden Bauelementeträger 110, 120 und 120-R von oder zu anderen Verarbeitungsplätzen der Bestückanlage transportiert. In der Haupt-Transportrichtung HT am Anfang und am Ende jedes Bestückautomaten 150-1, 150-2, 150-3 und 150-4 ist eine Übergabeeinrichtung 200-1, 200-2, 200-3, 200-4 bzw. 200-5 angeordnet.

Mittels der Übergabeeinrichtungen 200-1, 200-2, 200-3, 200-4 und 200-5 ist ein Übergeben von Bauelementeträgern 110, 120 und 120-R zwischen den parallelen Transportstrecken 140-2 und 140-3 am Anfang und am Ende jedes Bestückautomaten 150-1, 150-2, 150-3 und 150-4 möglich. Im Parallelbetrieb der Bestückautomaten 150-1, 150-2, 150-3 und 150-4 muß bei den beiden mittleren Bestückautomaten 150-2 und 150-3 jeweils eine Transportstrecke 140-2 oder 140-3 zum Weitertransport von bereits bestückten Bauelementeträgern 120 und eine Transportstrecke 140-3 bzw. 140-2 zum Transport von zu bestückenden Bauelementeträgern 110 zur Verfügung stehen.

Bei dem in Haupt-Transportrichtung HT gesehen ersten Bestückautomaten 150-1 wird eine Transportstrecke 140-2 oder 140-3 zum Zuführen von nicht bestückten Bauelementetragern 110 verwendet. Die andere Transportstrecke 140-3 bzw. 140-2 kann ausschließlich für den Transport von bereits bestückten Bauelementeträgern 120-R in der Gegeh-Transportrichtung GT verwendet werden.

Bei dem in Haupt-Transportrichtung HT gesehen letzten Bestückautomaten 150-4 muß eine der Transportstrecken 140-2 oder 140-3 für den Transport von bereits bestückten Bauelementeträgern 120 in der Haupt-Transportrichtung HT zur Verfügung stehen. Die andere der Transportstrecken 140-3 bzw. 140-2 kann ausschließlich für den Transport in der Gegen-Transportrichtung GT verwendet werden.

Bei den beiden mittleren Bestückautomaten 150-2 und 150-3 ist eine kontinuierliche Verwendung einer der Transportstrecken 140-2 und 140-3 in der Gegen-Transportrichtung GT nicht ohne Behindern der Versorgung der in Haupt-Transportrichtung HT nachfolgenden Bestückautomaten 150-3 bzw. 150-4 möglich. Zur weiteren Verbesserung können deshalb an den drei mittleren Übergabeeinrichtungen 200-2, 200-3 und 200-4 Zwischenspeicher 250 vorgesehen sein, in welchen die in der Gegen-Transportrichtung GT zu transportierenden Bauelementeträger 120-R zwischengespeichert werden können.

Wenn die Transportstrecken der mittleren Bestückautomaten 150-2 und 150-3 nicht zum Transportieren von bereits bestückten Bauelementeträgern 120 oder zum Zuführen von unbestückten Bauelementeträgern 110 in der Haupt-Transportrichtung HT verwendet werden, weil bereits alle Bestückplätze der Bestückautomaten 150-3 und 150-4 besetzt sind, kann jede der an den Bestückautomaten 150-2 und 150-3 freien Transportstrecken 140-2 und 140-3 für den Transport von in der Gegen-Transportrichtung GT zu transportierenden Bauelementeträgern 120-R verwendet werden. Somit ist ein effektiver Betrieb der Bestückanlage nach der bevorzugten Ausführungsform der Erfindung möglich, ohne daß die Verarbeitung an den Verarbeitungsplätzen durch den Transport in der Gegen-Transportrichtung GT gestört ist.

## Patentansprüche

1. Verfahren zum Betreiben einer Anlage zum Bestücken von Bauelementeträgern (110, 120, 120-R) mit elektrischen Bauelementen, wobei die Anlage eine Mehrzahl von Verarbeitungsplätzen (150, 160, 180, 170, 190) aufweist, welche über eine oder mehrere Transportstrecken (130, 140) verbunden sind, mittels der die Bauelementeträger (110, 120, 120-R) in einer Haupt-Transportrichtung (HT) transportiert werden, mit folgenden Schritten:
• Transportieren von Bauelementeträgern (110, 120) über die Transportstrecke (130, 140) in der Haupt-Transportrichtung (HT) zu den Verarbeitungsplätzen (150, 160, 180, 170, 190),
• Verarbeiten der Bauelementeträger (110, 120) und/oder der elektrischen Bauelemente an den Verarbeitungsplätzen (150, 160, 180, 170, 190),
• zeitweises Umkehren der Haupt-Transportrichtung (HT) einer oder mehrerer der Transportstrecken (130, 140) unter Transportieren der Bauelementeträger (120-R) von einem Verarbeitungsplatz (150, 160, 180, 170, 190) in der Gegen-Transportrichtung (GT) zu einem anderen Verarbeitungsplatz (150, 160, 180, 170, 190),
wobei teilweise bestückte Bauelementeträger (120-R) in der Gegen-Transportrichtung (GT) transportiert werden.

2. Verfahren nach Anspruch 1, wobei die Bauelementeträger (120-R) nach dem Transportieren in der Gegen-Transportrichtung (GT) erneut in der Haupt-Transportrichtung (HT) zu den Verarbeitungsplätzen (150, 160, 180, 170, 190) transportiert werden.

3. Verfahren nach Anspruch 1 bis 2, wobei vor dem Umkehren der Haupt-Transportrichtung (HT) geprüft wird, ob die Transportstrecke (130, 140) für den Transport in der Gegen-Transportrichtung (GT) frei ist.

4. Verfahren nach Anspruch 1 bis 3, wobei die Bauelementeträger (120-R) vor dem Transportieren in der Gegen-Transportrichtung (GT) zwischengespeichert werden.

5. Verfahren nach Anspruch 4, wobei die Bauelementeträger (120-R) nach dem Zwischenspeichern einzeln in der Gegen-Transportrichtung (GT) transportiert werden.

6. Anlage zum Bestücken von Bauelementträgern zur Durchführung des Verfahrens nach einem der Ansprüche 1 bis 5 mit einer Mehrzahl von Verarbeitungsplätzen (150, 160, 170, 180, 190) welche über eine oder mehrere Transportstrecken (130, 140) verbunden sind, mitltels der die Bauelementträger (110,120,120-R) in einer Haupt-Transportrichtung CHT) transportiert werden, **dadurch gekennzeichnet, dass**
• die Haupt-Transportrichtung (HT) der Transportstrecken (130, 140) für Transporte von einem Verarbeitungsplatz (150, 160, 170, 180, 190) zu einem anderen Verarbeitungsplatz (150, 160, 170, 180, 190) selektiv umkehrbar ist.

7. Anlage nach Anspruch 6, **dadurch gekennzeichnet, dass** eine mit den Transportstrecken (130, 140) und/oder mit den Verarbeitungsplätzen (150, 160, 170, 180, 190) gekoppelte Steuereinheit vorgesehen ist, von welcher auf Basis von ermittelten Zustandsinformationen der Transportstrecken (130, 140) überprüfbar ist, ob das Umkehren der Haupt-Transportrichtung (HT) ohne Beeinträchtigung der Verarbeitung durch die Verarbeitungsplätze (150, 160, 180, 170, 190) durchführbar ist.

8. Anlage nach Anspruch 6 oder 7, wobei zwei oder mehr Transportstrecken (130, 140) sowie eine oder mehrere Übergabeeinrichtungen (200) vorgesehen sind, von welchen Bauelementeträger (110, 120, 120-R) zwischen den Transportstrecken (130, 140) übergebbar sind, **dadurch gekennzeichnet, dass**
• die Haupt-Transportrichtung (HT) der Übergabeeinrichtungen (200) selektiv umkehrbar ist.

9. Anlage nach Anspruch 8, wobei mindestens eine Transportstrecke (130) durch die Verarbeitungsplätze (150, 160, 180, 170, 190) verläuft und die Übergabeeinrichtungen (200) vor und/oder nach den Verarbeitungsplätzen (150, 160, 180, 170, 190) angeordnet sind.

10. Anlage nach Anspruch 8 oder 9, wobei die Übergabeeinrichtungen (200) Zwischenspeicher (250) aufweisen, in welchen verarbeitete, teilweise verarbeitete und/oder unverarbeitete Bauelementeträger (110, 120, 120-R) speicherbar sind.

11. Übergabeeinrichtung (200) für eine Bestückanlage mit wenigstens zwei Transportstrecken (130, 140) für Bauelementeträger (110, 120, 120-R) und einer Mehrzahl von über die Transportstrecken (130, 140) verbundenen Verarbeitungsplätzen (150, 160, 180, 170, 190) zum Verarbeiten von Bauelementeträgern und/oder elektrischen Bauelementen, wobei die Übergabeeinrichtung (200) wenigstens eine Teiltransportstrecke (210) aufweist, die vertikal und/oder horizontal verschiebbar ist und zumindest temporär mit den Transportstrecken (130, 140) fluchtet, wobei
• die Haupt-Transportrichtung (HT) der Teiltransportstrecken (210) der Übergabeeinrichtungen (200) selektiv umkehrbar ist,
• die Übergabeeinrichtung (200) einen Zwischenspeicher (250) aufweist, in welchen teilweise und/oder vollständig bestückte Bauelementeträger (110, 120, 120-R) speicherbar sind, und
• der Zwischenspeicher (250) als horizontal und/oder vertikal verschiebbare Teiltransportstrecke (260) ausgebildet ist, welche zum Einspeichern oder Ausgeben von Bauelementeträgern (110, 120, 120-R) zumindest temporär mit den Transportstrecken (130, 140) fluchtet.

12. Übergabeeinrichtung nach Anspruch 11 für eine Bestückanlage, bei welcher die Transportstrecken (130, 140) jeweils als eine Mehrzahl von parallelen Transportstrecken (130, 140) mit festem Abstand zueinander ausgebildet sind, **dadurch gekennzeichnet, dass**
• die Teiltransportstrecken (210, 260) als eine der Mehrzahl entsprechenden Anzahl von parallelen Teiltransportstrecken (210, 260) ausgebildet sind, welche zueinander den festen Abstand aufweisen, und
• die parallelen Teiltransportstrecken (210, 260) auf einem gemeinsamen, horizontal und/oder vertikal zu den Transportstrecken (130, 140) verschiebbaren Träger gehalten sind.

## Claims

1. Method for the operation of a unit for placing electrical components on component supports (110, 120, 120-R), the unit having a plurality of processing locations (150, 160, 180, 170, 190), which are connected by means of one or more transport runs (130, 140), by means of which the component supports (110, 120, 120-R) are transported in a main transporting direction (HT), with the following steps:
• transporting of component supports (110, 120) over the transport run (130, 140) to the processing locations (150, 160, 180, 170, 190) in the main transporting direction (HT),
• processing the component supports (110, 120) and/or the electrical components at the processing locations (150, 160, 180, 170, 190),
• reversal, for a certain time, of the main transporting direction (HT) of one or more of the transport runs (130, 140), with the component supports (120-R) being transported from one processing location (150, 160, 180, 170, 190) to another processing location (150, 160, 180, 170, 190) in the opposite transporting direction (GT), component supports (120-R) provided with some of their components being transported in the opposite transporting direction (GT).

2. Method according to Claim 1, the component supports (120-R) being transported to the processing locations (150, 160, 180, 170, 190) once again in the main transporting direction (HT) after the transporting in the opposite transporting direction (GT).

3. Method according to Claims 1 to 2, it being checked before the reversal of the main transporting direction (HT) whether the transport run (130, 140) is free for the transport in the opposite transporting direction (GT).

4. Method according to Claims 1 to 3, the component supports (120-R) being buffer-stored before the transporting in the opposite transporting direction (GT).

5. Method according to Claim 4, the component supports (120-R) being transported individually in the opposite transporting direction (GT) after the buffer-storage.

6. Unit for the placement of components on component supports for carrying out the method according to one of Claims 1 to 5, with a plurality of processing locations (150, 160, 180, 170, 190) which are connected by means of one or more transport runs (130, 140), by means of which the component supports (110, 120, 120-R) are transported in a main transporting direction (HT), **characterized in that**
• the main transporting direction (HT) of the transport runs (130, 140) can be selectively reversed for transport operations from one processing location (150, 160, 170, 180, 190) to another processing location (150, 160, 170, 180, 190).

7. Unit according to Claim 6, **characterized in that** a control unit coupled to the transport runs (130, 140) and/or to the processing locations (150, 160, 170, 180, 190) is provided, from which unit it can be checked on the basis of determined information concerning the state of the transport runs (130, 140) whether the reversal of the main transporting direction (HT) can be carried out without impairment of the processing by the processing locations (150, 160, 170, 180, 190).

8. Unit according to Claim 6 or 7, two or more transport runs (130, 140) and one or more transfer devices (200) being provided, by which component supports (110, 120, 120-R) can be transported between the transport runs (130, 140), **characterized in that**
• the main transporting direction (HT) of the transfer devices (200) is selectively reversible.

9. Unit according to Claim 8, at least one transport run (130) running through the processing locations (150, 160, 180, 170, 190) and the transfer devices (200) being arranged upstream and/or downstream of the processing locations (150, 160, 180, 170, 190).

10. Unit according to Claim 8 or 9, the transfer devices (200) having buffer stores (250), in which processed, partly processed and/or unprocessed component supports (110, 120, 120-R) can be stored.

11. Transfer device (200) for a component placement unit with at least two transport runs (130, 140) for component supports (110, 120, 120-R) and a plurality of processing locations (150, 160, 180, 170, 190) connected by means of the transport runs (130, 140) for the processing of component supports and/or electrical components, the transfer device (200) having at least one transport subrun (210), which can be displaced vertically and/or horizontally and is at least temporarily in line with the transport runs (130, 140),
• the main transporting direction (HT) of the transport subruns (210) of the transfer device (200) being selectively reversible,
• the transfer device (200) having a buffer store (250), in which component supports (110, 120, 120-R) provided with some of or all their components can be stored, and
• the buffer store (250) being formed as a horizontally and/or vertically displaceable transport subrun (260), which for storing or delivering component supports (110, 120, 120-R) is at least temporarily in line with the transport runs (130, 140).

12. Transfer device according to Claim 11 for a component placement unit, in which the transport runs (130, 140) are in each case formed as a plurality of parallel transport runs (130, 140) with a fixed distance from one another, **characterized in that**
• the transport subruns (210, 260) are formed as a number, corresponding to the plurality, of parallel transport subruns (210, 260) which are at the fixed distance from one another, and the parallel transport subruns (210, 260) are held on a common support which can be displaced horizontally and/or vertically in relation to the transport runs (130, 140).

## Revendications

1. Procédé permettant de faire fonctionner une installation pour l'équipement de supports de composants (110, 120, 120-R) avec des composants électriques, l'installation présentant une pluralité de postes de traitement (150, 160, 180, 170, 190), qui sont reliés par un ou plusieurs tronçons de transport (130, 140), au moyen desquels les supports de composants (110, 120, 120-R) sont transportés dans une direction de transport principale (HT), comprenant les étapes suivantes :
• transport de supports de composants (110, 120) par le tronçon de transport (130, 140) dans la direction de transport principale (HT) aux postes de traitement (150, 160, 180, 170, 190),
• traitement des supports de composants (110, 120) et/ou des composants électriques sur les postes de traitement (150, 160, 180, 170, 190),
• inversion partielle de la direction de transport principale (HT) d'un ou de plusieurs tronçons de transport (130, 140) avec transport des supports de composants (120-R) d'un poste de traitement (150, 160, 180, 170, 190) dans la direction de transport opposée (GT) vers un autre poste de traitement (150, 160, 180, 170, 190),
des supports de composants (120-R) partiellement équipés étant transportés dans la direction de transport opposée (GT).

2. Procédé selon la revendication 1, les supports de composants (120-R) étant transportés après le transport dans la direction de transport opposée (GT) à nouveau dans la direction de transport principale (HT) vers les postes de traitement (150, 160, 180, 170, 190).

3. Procédé selon les revendications 1 à 2, dans lequel on vérifie avant l'inversion de la direction de transport principale (HT) si le tronçon de transport (130, 140) est libre pour le transport dans la direction de transport opposée (GT).

4. Procédé selon les revendications 1 à 3, les supports de composants (120-R) étant stockés provisoirement avant le transport dans la direction de transport opposée (GT).

5. Procédé selon la revendication 4, les supports de composants (120-R) étant transportés après le stockage intermédiaire individuellement dans la direction de transport opposée (GT).

6. Installation pour l'équipement de supports de composants pour la mise en oeuvre du procédé selon l'une quelconque des revendications 1 à 5 avec une pluralité de postes de traitement (150, 160, 170, 180, 190), qui sont reliés au moyen d'un ou de plusieurs tronçons de transport (130, 140), au moyen desquels les supports de composants (110, 120, 120-R) sont transportés dans une direction de transport principale (HT) **caractérisé en ce que**
• la direction de transport principale (HT) des tronçons de transport (130, 140) peut être inversée de façon sélective pour des transports d'un poste de traitement (150, 160, 170, 180, 190) vers un autre poste de traitement (150, 160, 170, 180, 190).

7. Installation selon la revendication 6, **caractérisée en ce qu'**il est prévu une unité de commande couplée avec les tronçons de transport (130, 140) et/ou avec les postes de traitement (150, 160, 170, 180, 190), par laquelle on peut vérifier sur la base d'informations d'état déterminées des tronçons de transport (130, 140) si l'inversion de la direction de transport principale (HT) peut être effectuée sans gêne du traitement par les postes de traitement (150, 160, 180, 170, 190).

8. Installation selon la revendication 6 ou 7, deux ou plus de deux tronçons de transport (130, 140) ainsi qu'un ou plusieurs dispositifs de transfert (200) étant prévus, par lesquels des supports de composants (110, 120, 120-R) peuvent être transmis entre des tronçons de transport (130, 140), **caractérisé en ce que**
• la direction de transport principale (HT) des directions de transfert (200) peut être inversée de façon sélective.

9. Installation selon la revendication 8, au moins un tronçon de transport (130) passant par les postes de traitement (150, 160, 180, 170, 190) et les dispositifs de transfert (200) étant disposés avant et/ou après les postes de traitement (150, 160, 180, 170, 190).

10. Installation selon la revendication 8 ou 9, les dispositifs de transfert (200) présentant des dispositifs de stockage intermédiaire (250), dans lesquels des supports de composants (110, 120, 120-R) traités, partiellement traités et/ou non-traités peuvent être stockés.

11. Dispositif de transfert (200) pour une installation d'équipement avec au moins deux tronçons de transport (130, 140) pour des supports de composants (110, 120, 120-R) et une pluralité de postes de traitement (150, 160, 180, 170, 190) reliés par les tronçons de transport (130, 140) pour le traitement de supports de composants et/ou de composants électriques, le dispositif de transfert (200) présentant au moins un tronçon de transport partiel (210), qui peut coulisser verticalement et/ou horizontalement et est aligné au moins temporairement avec les tronçons de transport (130, 140),
• la direction de transport principale (HT) des tronçons de transport partiels (210) des dispositifs de transfert (200) pouvant être inversée de façon sélective,
• le dispositif de transfert (200) présentant un dispositif de stockage intermédiaire (250) dans lequel des supports de composants (110, 120, 120-R) partiellement et/ou complètement équipés peuvent être stockés, et
• le dispositif de stockage intermédiaire (250) est réalisé sous forme de tronçon de transport partiel (260) pouvant coulisser horizontalement et/ou verticalement, qui est aligné au moins temporairement avec les tronçons de transport (130, 140) pour le stockage ou la sortie de supports de composant (110, 120, 120-R).

12. Dispositif de transfert selon la revendication 11 pour une installation d'équipement, sur lequel les tronçons de transport (130, 140) sont conçus respectivement sous la forme d'une pluralité de tronçons de transport (130, 140) parallèles avec un espacement fixe les uns par rapport aux autres, **caractérisé en ce que**
• les tronçons de transport partiels (210, 260) sont réalisés sous la forme d'un nombre, correspondant à la pluralité, de tronçons de transport partiels (210, 260) parallèles, qui présentent une même distance fixe les uns par rapport aux autres et
• les tronçons de transport partiels (210, 260) parallèles sont maintenus sur un support commun, pouvant coulisser horizontalement et/ou verticalement par rapport aux tronçons de transport (130, 140).
